# EUROPEAN PATENT SPECIFICATION

(11) **EP 3 339 851 B1**
(45) Date of publication and mention of the grant of the patent: **04.03.2020**
(21) Application number: 16878035.1
(22) Date of filing: 16.08.2016
(51) Int. Cl.: G01N 27/62, G01N 1/28, G01N 1/32

(54) **SILICON SUBSTRATE ANALYZING DEVICE AND METHOD FOR USING IT**
SILICIUMSUBSTRATANALYSEVORRICHTUNG UND METHODE ZUR BENUTZUNG
DISPOSITIF D'ANALYSE DE SUBSTRAT DE SILICIUM ET PROCÉDÉ DE L'UTILISER

(30) Priority: 22.12.2015 JP 2015249588
(43) Date of publication of application: 27.06.2018
(73) Proprietor: Ias Inc., Kunitachi-shi, Tokyo 186-0003 (JP)
(72) Inventor: KAWABATA, Katsuhiko, Kunitachi-shi Tokyo 186-0003 (JP); ICHINOSE, Tatsuya, Kunitachi-shi Tokyo 186-0003 (JP); HAYASHI, Takuma, Kunitachi-shi Tokyo 186-0003 (JP)
(74) Representative: Weickmann & Weickmann PartmbB
(86) International application number: PCT/JP2016/073881
(87) International publication number: WO 2017/110132

(56) References cited:
- WO-A1-2016/027607
- WO-A1-2016/039032
- JP-A- 2003 188 222
- JP-A- 2004 335 955
- JP-A- 2008 311 597
- JP-A- 2010 008 048
- JP-A- 2011 128 033
- JP-A- 2011 232 182
- JP-A- 2013 257 272
- JP-A- 2016 125 911
- US-A1- 2012 260 750

## Description

### Technical Field

The present invention relates to a device for analyzing impurities, such as trace metals, contained in a silicon substrate that is used in semiconductor production or the like, and more particularly to a silicon substrate analyzing device that is suitable in analyzing a silicon substrate having a thick nitride film or silicon oxide film formed on a silicon substrate surface to be analyzed.

### Background Art

In accordance with achievement of higher integration, there is a demand for an analyzing device capable of detecting impurities such as metals that affect the device characteristics in a silicon substrate, such as a wafer made of silicon, used for production of semiconductors and the like. A method in which an inductively coupled plasma mass spectrometer (ICP-MS) is used is known as one of the analyzing methods capable of detecting an amount of impurities such as metals in a silicon substrate even when the amount is extremely slight. In this analyzing method, in order to take out impurities such as metals contained in a silicon substrate in a form that can be introduced into an ICP-MS, the silicon substrate is etched by gas-phase decomposition method; the silicon substrate surface subjected to etching is scanned with an analysis liquid so that the impurities such as metals are transferred into the analysis liquid; and the analysis liquid is introduced into the ICP-MS so that the analysis may be performed (See, for example, Patent Document 1). Also, Patent Document 2 discloses a method in which impurities contained in a silicon substrate are taken into an analysis liquid by a substrate analyzing nozzle, and the analysis is performed.

Patent Document 3 is directed to an apparatus for measuring impurities on a wafer and a method for measuring impurities on a wafer. The apparatus for measuring impurities on a wafer comprises a wafer aligning device for aligning a wafer, a loading robot for moving and loading the aligned wafer, a rotation stage for rotating the loaded wafer, a scan robot for holding a natural oxide layer etching solution for the wafer and a metallic impurity recovery solution, and a container for receiving a predetermined etching solution and a recovery solution, wherein the scan robot removes an oxide layer on an edge region of the wafer.

Patent Document 4 is directed to a method for analyzing with high sensitivity metal contamination of a silicon wafer surface. In the method a silicon wafer with an oxide film is brought into contact with hydrogen fluoride gas while being cooled, whereby condensation (not including a silicon oxide component) is generated on the wafer surface. Thereby the oxide film on the silicon wafer surface is etched. After removal of the oxide film scanning is performed with a solution along the silicon wafer surface and then a metal component in the solution is analyzed.

### Related Art Document

### Patent Documents

Patent Document 1: JPH 11-281542 A
Patent Document 2: JP 2013-257272 A
Patent Document 3: US 2012/0260750 A1
Patent Document 4: JP 2010-008048 A

### Summary of the Invention

### Problems to be Solved by the Invention

In impurity analysis of a silicon substrate by use of the gas-phase decomposition method, an etching gas containing a vapor of hydrogen fluoride is brought into contact with a silicon substrate disposed in a gas-phase decomposition chamber so that a nitride film and an oxide film formed on the silicon substrate surface are decomposed, whereby impurities such as metals contained in these films are left as a residue on the silicon substrate. This is because the etching gas containing the vapor of hydrogen fluoride cannot etch the silicon substrate in a form of a bulk, so that the impurities are left as a residue on the silicon substrate. Then, with a substrate analyzing nozzle used on the silicon substrate surface on which the impurities are present as a residue, the silicon substrate surface is scanned with an analysis liquid which is a mixture liquid of hydrogen fluoride and hydrogen peroxide so that the impurities are taken into the analysis liquid, and the collected analysis liquid is subjected to ICP-MS analysis.

When the nitride film and the oxide film formed on the silicon substrate surface are thin, the analysis is less affected; however, when these films are thick, the following problems will occur. In the case of a nitride film, when gas-phase decomposition is performed with use of an etching gas of hydrogen fluoride, an ammonium fluoride-based white salt of Si(NH₄)ₓF_{y} is produced on the silicon substrate. When the nitride film is thick, this white salt increases in amount, so that the silicon concentration in the collected analysis liquid becomes high, and SiO₂ is deposited at an interface part of the ICP-MS to cause clogging, whereby the analysis precision is liable to decrease. In order to cope with this, there is a method of heating the silicon substrate to 160°C to 180°C with a hot plate or the like, so as to evaporate the white salt. However, in accordance with evaporation of the white salt, the impurities such as metals to be analyzed also evaporates together, so that a recovery rate of the impurities decreases. Further, when an ammonium fluoride-based white salt is heated and evaporated, the evaporated white salt adheres to a wall surface of a chamber or the like where the hot plate is disposed, and the adhered white salt may fall from the wall surface to cause contamination of the silicon substrate. Also, there is a need for maintenance to periodically remove the white salt adhered to the wall surface may be d. Further, in the case of an oxide film (SiO₂), when gas-phase decomposition is performed with use of an etching gas of hydrogen fluoride, Si(OH)₄ and H₂SiF₆ are produced and left as a residue on the silicon substrate. In the same manner as in the nitride film, this raises the silicon concentration in the collected analysis liquid and affects the analysis of the ICP-MS.

Under such circumstances, an object of the present invention is to provide a silicon substrate analyzing device with which impurities such as trace metals contained in a nitride film and an oxide film can be analyzed with a high precision with use of an ICP-MS even if the nitride film and the oxide film formed on a silicon substrate are thick, and in which the burden of maintenance of the device is also alleviated.

### Means for Solving the Problems

The present invention relates to a silicon substrate analyzing device according to claim 1, a method of analyzing impurities contained in a silicon substrate using the silicon substrate analyzing device according to claim 2, and the use of the silicon substrate analyzing device according to claim 3.

First, an instance of using the analysis means by inductively coupled plasma mass spectrometry with the silicon substrate analyzing device according to the present invention will be described. When analysis of a silicon substrate on which a thick nitride film or oxide film is formed is performed, the silicon substrate taken out from the load port by the substrate transportation robot is first transported to the gas-phase decomposition chamber and placed in the chamber. Further, an etching gas containing a vapor of hydrogen fluoride is brought into contact with the silicon substrate so that a gas-phase decomposition treatment may be performed. The silicon substrate subjected to this gas-phase decomposition treatment is transported and mounted onto the analysis stage of the analysis scan port by the substrate transportation robot. During this time, the substrate analyzing nozzle of the analysis scan port is filled with a high-concentration recovered liquid containing a mixture liquid of high-concentration hydrogen fluoride and hydrogen peroxide, and the silicon substrate surface is scanned with the substrate analyzing nozzle that holds this high-concentration recovered liquid at a tip end of the nozzle so that the products such as an ammonium fluoride-based white salt of Si(NH₄)ₓF_{y}, Si(OH)₄, and H₂SiF₆ are dissolved. Thus, the recovered high-concentration recovered liquid contains impurities such as metals that were present as a residue on the silicon substrate surface subjected to the gas-phase decomposition treatment.

Subsequently, the high-concentration recovered liquid recovered in the substrate analyzing nozzle is discharged and returned onto the silicon substrate surface, and the high-concentration recovered liquid is placed at specific positions on the silicon substrate surface. When the silicon substrate on which the high-concentration recovered liquid is placed is transported and placed into the drying chamber by the substrate transportation robot, the silicon substrate is subjected to heating and drying at about 100°C so that the high-concentration recovered liquid should be evaporated. In the case of an oxide film (SiO₂), silicon (Si) taken into the high-concentration recovered liquid undergoes the following reaction with hydrogen fluoride.

Si(OH)₄ + 4HF → SiF₄ + 4H₂O

That is, Si of the oxide film is turned into a gas of SiF₄ and decreases in amount by being removed from the silicon substrate surface.

Further, in the case of a nitride film, the ammonium fluoride-based white salt of Si(NH₄)ₓF_{y} produced by hydrogen fluoride undergoes the following reaction with an excessive amount of hydrogen fluoride.

Si(NH₄)ₓF_{y} + HF → SiF₄ + NH₄F

That is, Si of the nitride film is also turned into a gas of SiF₄ and decreases in amount by being removed from the silicon substrate surface.

The silicon substrate heated and dried in the drying chamber is again transported and mounted onto the analysis stage by the substrate transportation robot. During this time, the substrate analyzing nozzle is filled with an analysis liquid, and the silicon substrate surface is scanned with the analysis liquid so that the impurities are taken into the analysis liquid. The analysis liquid recovered by the substrate nozzle is put into the analysis container provided in the analysis liquid collecting means and reaches the nebulizer. Then, the analysis liquid of the nebulizer is analyzed by ICP-MS. This analysis liquid has a low concentration of Si even when the nitride film or oxide film is thick, so that a phenomenon of deposition of SiO₂ is also suppressed, and the analysis by ICP-MS can be stably performed. Therefore, by the silicon substrate analyzing device according to the present invention, impurities such as trace metals contained in a nitride film or oxide film can be analyzed with a high precision by ICP-MS even if the nitride film or oxide film formed on the silicon substrate is thick.

In the silicon substrate analyzing device according to the present invention, the silicon substrate on which the high-concentration recovered liquid remains is preferably heated and dried at a heating temperature of 100°C to 130°C in the drying chamber. When the heating temperature exceeds 130°C, the impurities such as metals tend to be evaporated together at the time of evaporation. When the heating temperature is lower than 100°C, heating and drying tend to require a long period of time, and the high-concentration recovered liquid may not be evaporated with certainty.

The high-concentration recovered liquid to be used in the present invention is a mixture liquid of hydrogen fluoride of 10% to 30% volume concentration and hydrogen peroxide of 1% to 30% volume concentration. Usually, the mixture liquid of hydrogen fluoride and hydrogen peroxide used as the analysis liquid is prepared with use of hydrogen fluoride of 2% to 4% volume concentration and hydrogen peroxide of 2% to 30% volume concentration; however, the high-concentration recovered liquid of the present invention is prepared with use of hydrogen fluoride of 10% to 30% volume concentration. With hydrogen fluoride of less than 10%, silicon (Si) will not be removed sufficiently in a form of SiF₄ tends to be insufficient. On the other hand, with hydrogen fluoride of more than 30%, the silicon substrate surface becomes hydrophilic, whereby recovery of the high-concentration recovered liquid or the analysis liquid will be hindered. An example of a high-concentration recovered liquid is a mixture liquid of hydrogen fluoride of 20% to 30% volume concentration and hydrogen peroxide of 3% to 5% volume concentration.

In the silicon substrate analyzing device according to the present invention, the recovered high-concentration recovered liquid can be discharged all together at one place on the surface of the silicon substrate when the recovered high-concentration recovered liquid is discharged and returned onto the silicon substrate surface. When the silicon substrate to which the high-concentration recovered liquid is returned at one specific place is heated and dried and then the silicon substrate is scanned with the analysis liquid, it is sufficient that the one specific place at which the high-concentration recovered liquid is returned is scanned with the analysis liquid, so that the analysis speed can be increased. Alternatively, the recovered high-concentration recovered liquid may be discharged at a plurality of places by being dispersed on the surface of the silicon substrate when the recovered high-concentration recovered liquid is discharged and returned onto the silicon substrate surface. When the high-concentration recovered liquid is discharged onto the silicon substrate surface by being dispersed, the heating and drying time in the drying chamber can be shortened.

### Advantageous Effects of the Invention

As described above, the silicon substrate analyzing device of the present invention is capable of analyzing impurities such as trace metals contained in a nitride film or oxide film with a high precision by ICP-MS even if the nitride film or oxide film formed on the silicon substrate is thick. Further, the burden of maintenance of the device can also be alleviated. Furthermore, the silicon substrate analyzing device can perform in a fully-automatic manner, all the processes in the analysis of the silicon substrate, from the pretreatments (gas-phase decomposition treatment, treatment with the high-concentration recovered liquid, treatment with the analysis liquid, and the like) to the analysis by ICP-MS, so that impurities such as trace metals contained in the silicon substrate can be analyzed quickly and efficiently, and moreover, contamination from the environment and the operators can be avoided.

### Brief Description of the Drawings

Fig. 1 is a view schematically illustrating a silicon substrate analyzing device, and
Fig. 2 is a sectional view schematically illustrating a substrate analyzing nozzle.

### Description of Embodiments

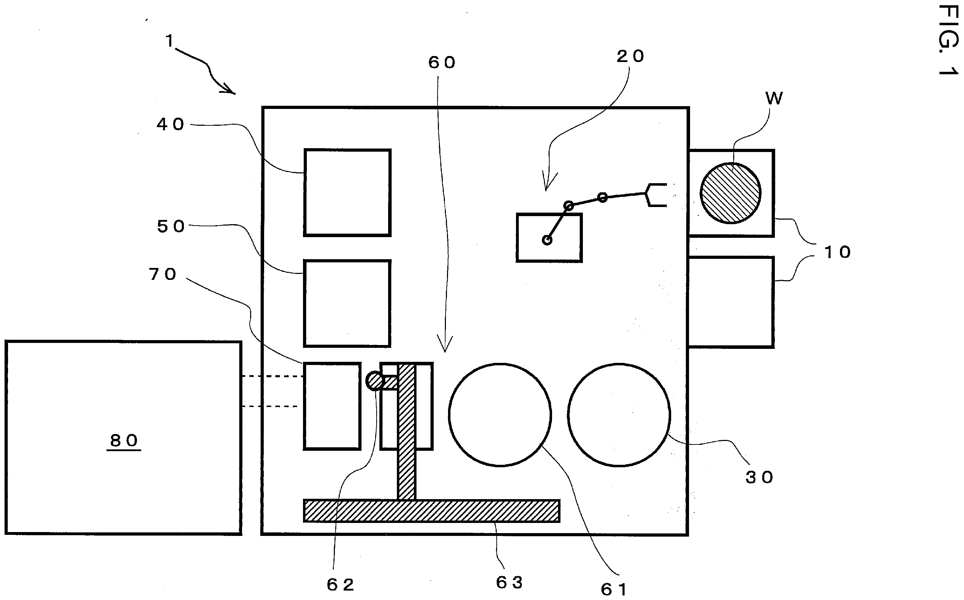

Hereafter, embodiments of the present invention will be described with reference to the drawings. Fig. 1 is a view schematically illustrating a silicon substrate analyzing device in the present embodiment. The silicon substrate analyzing device 1 of Fig. 1 includes a load port 10 for placing a storage cassette, not illustrated, that stores a silicon substrate W to be analyzed; a substrate transportation robot 20 capable of taking out, transporting, and placing the silicon substrate W; an aligner 30 for adjusting the position of the silicon substrate; a gas-phase decomposition chamber 40 for etching the silicon substrate W; a drying chamber 50 for a heating and drying treatment; an analysis scan port 60 having an analysis stage 61 for mounting the silicon substrate W, a substrate analyzing nozzle 62 for scanning a surface of the silicon substrate mounted on the analysis stage 61 with an analysis liquid and recovering the analysis liquid; a nozzle operating robot 63 for operating the substrate analyzing nozzle 62, a high-concentration recovered liquid, and the analysis liquid; an autosampler 70 (analysis liquid collecting means) having an analysis container, not illustrated, into which the high-concentration recovered liquid and the analysis liquid collected by the substrate analyzing nozzle 62 are put; a nebulizer, not illustrated; and an inductively coupled plasma mass spectrometer (ICP-MS) 80 for performing inductively coupled plasma mass spectrometry.

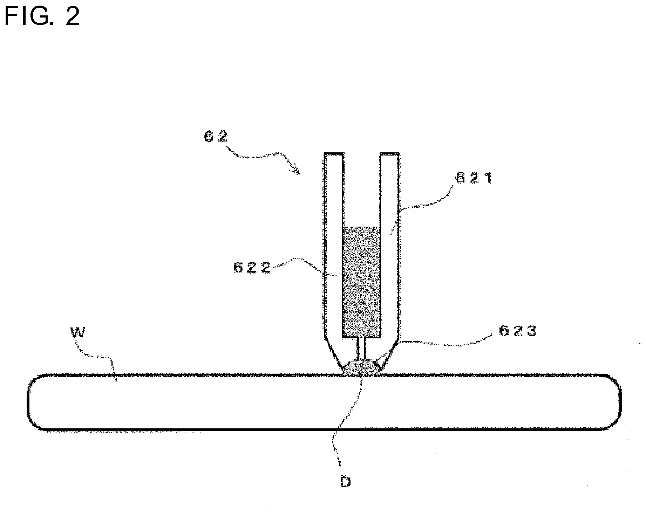

Fig. 2 is a sectional view schematically illustrating the substrate analyzing nozzle 62. The substrate analyzing nozzle 62 subjected to operations such as transportation and movement by the nozzle operating robot, not illustrated, is adapted to be capable of loading, sucking, and discharging a solution such as the analysis liquid in a liquid pool 622 of a nozzle main body 621. For example, when the silicon substrate surface is scanned with use of the analysis liquid D, the analysis liquid is held in a dome-shaped solution holding section 623 disposed at the tip end of the nozzle main body 621 so that the analysis liquid D is brought into contact with the silicon substrate W surface, and the nozzle operating robot is operated so that the analysis liquid D is moved on the silicon substrate surface, whereby impurities such as trace metals to be analyzed are transferred into the analysis liquid.

Next, a procedure for analysis by the silicon substrate analyzing device of the present embodiment will be described. First, the silicon substrate W to be analyzed is taken out from the load port 10 by the substrate transportation robot 20 and transported to the aligner 30 disposed in the device so that the position of the silicon substrate W is adjusted. Then, the silicon substrate W is transported to the gas-phase decomposition chamber 40 and placed in the chamber.

In the gas-phase decomposition chamber 40, an etching gas containing a vapor of hydrogen fluoride is sprayed onto the silicon substrate W, and a gas-phase decomposition treatment of etching the silicon substrate surface is performed. By this gas-phase decomposition treatment, impurities such as metals and silicon-containing compounds contained in the film such as an oxide film on the silicon substrate surface remain as a residue on the silicon substrate.

The silicon substrate W having undergone the gas-phase decomposition treatment is transported to the analysis stage 61 and placed on the stage. Further, the nozzle operating robot 63 operates to allow the substrate analyzing nozzle 62 to be filled with the high-concentration recovered liquid from the analysis scan port 60. The substrate analyzing nozzle 62 filled with the high-concentration recovered liquid moves onto the silicon substrate, ejects a part of the high-concentration recovered liquid onto the silicon substrate, and scans the silicon substrate W surface in a state in which the high-concentration recovered liquid is held at the tip end of the nozzle main body. By this, impurities such as metals and silicon-containing compounds remaining as a residue on the silicon substrate are taken into the high-concentration recovered liquid. After scanning with the high-concentration recovered liquid, the whole amount of the high-concentration recovered liquid recovered into the substrate analyzing nozzle 62 is discharged onto the silicon substrate. The site for discharge at this time may be one place or a plurality of places.

The silicon substrate W on which the high-concentration recovered liquid is mounted is transported to the drying chamber 50 and placed in the chamber. Further, the silicon substrate W is heated and dried at a temperature of 100°C to 130°C. By the heating and drying in the drying chamber 50, silicon (Si) that is present on the silicon substrate is volatilized and removed a gas of SiF₄.

The silicon substrate W subjected to the heating and drying is transported to the analysis stage 61 by the substrate transportation robot 20 and mounted on the stage. Further, the nozzle operating robot 63 operates to let the substrate analyzing nozzle 62 be filled with the analysis liquid from the analysis scan port 60. The substrate analyzing nozzle filled with the analysis liquid moves onto the silicon substrate W, discharges a part of the analysis liquid, and scans the silicon substrate W surface in a state in which the analysis liquid is held at the tip end of the nozzle main body. By this, impurities such as metals remaining as a residue on the silicon substrate W are taken into the analysis liquid. This scanning with the analysis liquid can be performed in accordance with the place where the high-concentration recovered liquid is discharged. For example, when the high-concentration recovered liquid is discharged at one place, the scanning can be performed around the place of discharge. Alternatively, when the high-concentration recovered liquid is discharged on a plurality of places, the whole surface of the silicon substrate only has to be scanned.

The analysis liquid that has taken the impurities in by scanning the silicon substrate surface is put into an analysis container, not illustrated, made of PTFE and referred to as a vial that is provided in the autosampler (analysis liquid collecting means) 70. The analysis liquid in the analysis container is sucked by the nebulizer and subjected to analysis by ICP-MS.

### Example 1:

Description will be given on a result of analyzing a silicon substrate having a 12-inch (30,48 cm) diameter on which an oxide film (SiO₂) having a thickness of 500 nm was formed. A mixture liquid of hydrogen fluoride of 25% volume concentration and hydrogen peroxide of 5% volume concentration was used as the high-concentration recovered liquid. Also, a mixture liquid of hydrogen fluoride of 3% volume concentration and hydrogen peroxide of 4% volume concentration was used as the analysis liquid. ELAN DRC II manufactured by PerkinElmer, Inc. was used as the ICP-MS serving as an analyzer.

First, after the gas-phase decomposition treatment was performed without the use of the high-concentration recovered liquid, the whole surface of the silicon substrate was scanned with the analysis liquid, and impurities such as metals were taken into the analysis liquid. In this case, the Si concentration in 1 ml of the recovered analysis liquid was about 5000 ppm.

Next, after the gas-phase decomposition treatment was performed, the whole surface of the silicon substrate was scanned with the high-concentration recovered liquid (about 1 ml). Then, the whole amount of the high-concentration recovered liquid was discharged to one place, and the silicon substrate was subjected to a heating and drying treatment at 100°C for 10 minutes in the drying chamber. Then, the whole surface of the silicon substrate was scanned with the analysis liquid, and impurities such as metals were taken into the analysis liquid. The Si concentration in 1 ml of the recovered analysis liquid assumed an extremely low value of about 50 ppm.

### Example 2:

Description will be given on a result of analyzing a silicon substrate having a 12-inch (30,48 cm) diameter on which a nitride film (SiₓN_{y}) having a thickness of 100 nm was formed. The same high-concentration recovered liquid and analysis liquid as in Example 1 were used.

First, after the gas-phase decomposition treatment was performed without the use of the high-concentration recovered liquid, the whole surface of the silicon substrate was scanned with the analysis liquid, and impurities such as metals were taken into the analysis liquid. In this case, the Si concentration in 1 ml of the recovered analysis liquid was about 10000 ppm.

Next, after the gas-phase decomposition treatment was performed, the whole surface of the silicon substrate was scanned with the high-concentration recovered liquid (about 1 ml). Then, the whole amount of the high-concentration recovered liquid was discharged on one place, and the silicon substrate was subjected to a heating and drying treatment at 100°C for 10 minutes in the drying chamber. Then, the whole surface of the silicon substrate was scanned with the analysis liquid, and impurities such as metals were taken into the analysis liquid. The Si concentration in 1 ml of the collected analysis liquid assumed an extremely low value of about 70 ppm.

Furthermore, analysis sensitivity of the ICP-MS in analyzing the silicon substrate on which the nitride film of Example 2 was formed will be described. First, when the whole surface of the silicon substrate was scanned with the analysis liquid so that impurities such as metals are taken into the analysis liquid after the gas-phase decomposition treatment was performed without the use of the high-concentration recovered liquid, the sensitivity began to decrease immediately after introduction of the sample (analysis liquid) into the ICP-MS, and the sensitivity decreased to 50% after the sample was introduced for 5 minutes. This is because SiO₂ was deposited at the interface part of the ICP-MS to clog the pores. On the other hand, when the treatment with the high-concentration recovered liquid was performed after the gas-phase decomposition treatment and, the whole surface of the silicon substrate was scanned with the analysis liquid after the drying and heating treatment, and impurities such as metals are taken into the analysis liquid, little decrease in the sensitivity occurred even when the sample (analysis liquid) was introduced into the ICP-MS, and decrease in the sensitivity was within 5% even when the sample was introduced for 5 minutes.

### Industrial Applicability

The present invention is capable of analyzing quickly impurities such as trace metals contained in a nitride film or oxide film and with a high precision by ICP-MS even when the nitride film or oxide film formed on a silicon substrate is thick, so that the efficiency of semiconductor production can be improved. Furthermore, the present invention allows all the processes, from the pretreatments (gas-phase decomposition treatment, treatment with the high-concentration recovered liquid, treatment with the analysis liquid, and the like) of the silicon substrate to the analysis by ICP-MS to be performed automatically, so that the steps of analyzing the silicon substrate can be performed more quickly, and moreover, contamination from the environment and the operators can be avoided.

### Reference Signs List

- 1: Silicon substrate analyzing device
- 10: Load port
- 20: Substrate transportation robot
- 30: Aligner
- 40: Gas-phase decomposition chamber
- 50: Drying chamber
- 60: Analysis scan port
- 70: Autosampler
- 80: Inductively-coupled plasma analyzer
- D: Analysis liquid
- W: Silicon substrate

## Claims

1. A silicon substrate analyzing device comprising:
a load port (10) for placing thereon a storage cassette that stores a silicon substrate (W) to be analyzed, wherein an oxide film and/or a nitride film has been formed on the silicon substrate (W);
a substrate transportation robot (20) capable of taking out, transporting, and installing the silicon substrate (W) stored in the load port (10);
an aligner (30) for adjusting a position of the silicon substrate (W);
a drying chamber (50) for heating and drying the silicon substrate (W);
a gas-phase decomposition chamber (40) for etching the silicon substrate (W) with an etching gas;
an analysis scan port (60) having an analysis stage (61) for mounting thereon the silicon substrate (W), and a substrate analyzing nozzle (62) for scanning a surface of the silicon substrate (W) mounted on the analysis stage (61) with an analysis liquid (D) and collecting the analysis liquid (D) into which the impurities such as trace metals have been transferred, wherein the analysis liquid (D) is a mixture liquid of hydrogen fluoride and hydrogen peroxide;
an analysis liquid collecting means (70) having an analysis container for putting into the analysis liquid (D) recovered by the substrate analyzing nozzle (62);
a nebulizer sucking the analysis liquid (D), which has been put in the analysis container; and
an analysis means for performing inductively coupled plasma mass spectrometry on the analysis liquid (D) supplied from the nebulizer,
**characterized in that**
the substrate analyzing nozzle (62) holding a high-concentration recovered liquid at a tip end of the nozzle (62) is adapted to scan the silicon substrate surface, wherein the high-concentration recovered liquid is a mixture liquid of hydrogen fluoride of 10% to 30% volume concentration and hydrogen peroxide of 1% to 30% volume concentration; and
the substrate analyzing nozzle (62) is further adapted to subsequently discharge and return onto the silicon substrate surface the high-concentration recovered liquid.

2. A method of analyzing impurities contained in a silicon substrate using the silicon substrate analyzing device according to claim 1, comprising
taking out a silicon substrate (W) from a load port (10), transporting the silicon substrate to and placing it in a gas-phase decomposition chamber (40) by a substrate transportation robot (20), wherein the silicon substrate (W) is brought into contact with an etching gas containing a vapor of hydrogen fluoride to perform a gas-phase decomposition treatment;
transporting and mounting the silicon substrate (W) having been subjected to the gas-phase decomposition treatment onto the analysis stage (61) of the analysis scan port (60) by the substrate transportation robot (20);
filling a substrate analyzing nozzle (62) of the analyzing scan port (60) with a high-concentration recovered liquid being a mixture liquid of hydrogen fluoride of 10% to 30% volume concentration and hydrogen peroxide of 1% to 30% volume concentration;
scanning the silicon substrate surface with the substrate analyzing nozzle (62) that holds the high-concentration recovered liquid at a tip end of the nozzle (62);
recovering the high-concentration recovered liquid containing impurities;
discharging and returning the high-concentration recovered liquid recovered in the substrate analyzing nozzle (62) onto the silicon substrate surface;
transporting and placing the silicon substrate (W) on which the high-concentration recovered liquid was placed into a drying chamber (50) by the substrate transportation robot (20);
subjecting the silicon substrate (W) to heating and drying;
transporting and mounting the heated and dried silicon substrate (W) onto the analysis stage (61) by the substrate transportation robot (20);
filling the substrate analyzing nozzle (62) with an analysis liquid (D) being a mixture liquid of hydrogen fluoride and hydrogen peroxide, and scanning the silicon substrate surface with the analysis liquid;
recovering the analysis liquid (D) by the substrate analyzing nozzle (62), putting it into an analysis container provided in an analysis liquid collection means (70); and
analyzing the analysis liquid (D) by inductively coupled plasma mass spectrometry (ICP-MS).

3. Use of the silicon substrate analyzing device according to claim 1 for analyzing impurities contained in a silicon substrate,
wherein a silicon substrate (W) is taken out from a load port (10) by a substrate transportation robot (20), transported to and placed in a gas-phase decomposition chamber (40), wherein the silicon substrate (W) is brought into contact with an etching gas containing a vapor of hydrogen fluoride to perform a gas-phase decomposition treatment;
the silicon substrate (W) having been subjected to the gas-phase decomposition treatment is transported and mounted onto the analysis stage (61) of the analysis scan port (60) by the substrate transportation robot (20);
a substrate analyzing nozzle (62) of the analysis scan port (60) is filled with a high-concentration recovered liquid being a mixture liquid of hydrogen fluoride of 10% to 30% volume concentration and hydrogen peroxide of 1% to 30% volume concentration and the silicon substrate surface is scanned with the substrate analyzing nozzle (62) that holds the high-concentration recovered liquid at a tip end of the nozzle (62);
the high-concentration recovered liquid is recovered containing impurities and the high-concentration recovered liquid is discharged and returned onto the silicon substrate surface;
the silicon substrate (W) on which the high-concentration recovered liquid was placed is transported and placed into a drying chamber (50) by the substrate transportation robot (20) and the silicon substrate (W) is subjected to heating and drying;
the heated and dried silicon substrate (W) is transported and mounted onto the analysis stage (61) by the substrate transportation robot (20) and the substrate analyzing nozzle (62) is filled with an analysis liquid (D) being a mixture liquid of hydrogen fluoride and hydrogen peroxide;
the silicon substrate surface is scanned with the analysis liquid (D), the analysis liquid (D) is recovered by the substrate analyzing nozzle (62) and is put into an analysis container provided in an analysis liquid collection means (70); and
the analysis liquid (D) is analyzed by inductively coupled plasma mass spectrometry (ICP-MS).

4. The method according to claim 2 or the use according to claim 3, wherein the silicon substrate (W) is heated and dried in the drying chamber (50) at a heating temperature of 100°C to 130°C.

5. The method according to claim 2 or the use according to claim 3, wherein the high-concentration recovered liquid is discharged and returned onto the silicon substrate surface at one specific place, or at a plurality of places by being dispersed on the silicon substrate surface.

## Patentansprüche

1. Siliziumsubstrat-Analysevorrichtung, umfassend:
eine Aufgabeöffnung (10), um darauf eine Vorratskassette anzuordnen, die ein zu analysierendes Siliziumsubstrat (W) bevorratet, worin ein Oxidfilm und/oder ein Nitridfilm auf dem Siliziumsubstrat (W) ausgebildet wurde;
einen Substrattransportroboter (20), der in der Lage ist, das in der Aufgabeöffnung (10) bevorratete Siliziumsubstrat (W) herauszunehmen, zu transportieren und einzusetzen;
eine Ausrichteinrichtung (30) zum Einstellen einer Position des Siliziumsubstrats (W);
eine Trockenkammer (50) zum Erwärmen und Trocknen des Siliziumsubstrats (W);
eine Gasphasenzersetzungskammer (40) zum Ätzen des Siliziumsubstrats (W) mit einem Ätzgas;
eine Analyseabtastungsöffnung (60) mit einer Analyseplattform (61) zum Anbringen des Siliziumsubstrats (W) darauf, und einer Substratanalysedüse (62) zum Abtasten einer Oberfläche des auf der Analyseplattform (61) angebrachten Siliziumsubstrats (W) mit einer Analyseflüssigkeit (D) und zum Sammeln der Analyseflüssigkeit (D), in die die Verunreinigungen, wie z.B. Spurenmetalle, übergeführt wurden, worin die Analyseflüssigkeit (D) eine Mischflüssigkeit aus Fluorwasserstoff und Wasserstoffperoxid ist;
eine Analyseflüssigkeitssammeleinrichtung (70) mit einem Analysebehälter zum Einfüllen der von der Substratanalysedüse (62) gewonnenen Analyseflüssigkeit (D);
einen Zerstäuber, der die in den Analysebehälter eingefüllte Analyseflüssigkeit (D) absaugt; und eine Analyseeinrichtung zum Durchführen einer induktiv gekoppelten Plasmamassenspektrometrie an der von dem Zerstäuber zugeführten Analyseflüssigkeit (D),
**dadurch gekennzeichnet, dass** die Substratanalysedüse (62), die eine hochkonzentrierte gewonnene Flüssigkeit an einem Spitzenende der Düse (62) hält, so eingerichtet ist, dass sie die Siliziumsubstratoberfläche abtastet, worin die hochkonzentrierte gewonnene Flüssigkeit ein Flüssigkeitsgemisch aus Fluorwasserstoff mit einer Konzentration von 10 Volumen-% bis 30 Volumen-% und Wasserstoffperoxid mit einer Konzentration von 1 Volumen-% bis 30 Volumen-% ist; und
die Substratanalysedüse (62) weiterhin so eingerichtet ist, um anschließend die hochkonzentrierte gewonnene Flüssigkeit abzugeben und auf die Siliziumsubstratoberfläche zurückzuführen.

2. Verfahren zum Analysieren von Verunreinigungen, die in einem Siliziumsubstrat enthalten sind, unter Verwendung der Siliziumsubstrat-Analysevorrichtung nach Anspruch 1, umfassend
Entnehmen eines Siliziumsubstrats (W) aus einer Beschickungsöffnung (10), Transportieren des Siliziumsubstrats zu einer Gasphasen-Zersetzungskammer (40) und Einbringen desselben in diese durch einen Substrattransportroboter (20), worin das Siliziumsubstrat (W) mit einem Ätzgas, das einen Dampf aus Fluorwasserstoff enthält, in Kontakt gebracht wird, um eine Gasphasen-Zersetzungsbehandlung durchzuführen;
Transportieren und Anbringen des Siliziumsubstrats (W), das der Gasphasenzersetzungsbehandlung unterzogen worden ist, auf die Analyseplattform (61) der Analyseabtastöffnung (60) durch den Substrattransportroboter (20);
Füllen einer Substratanalysedüse (62) der Analyseabtastöffnung (60) mit einer hochkonzentrierten gewonnenen Flüssigkeit, die eine Flüssigkeitsgemisch aus Fluorwasserstoff mit einer Konzentration von 10 Volumen-% bis 30 Volumen-% und Wasserstoffperoxid mit einer Konzentration von 1 Volumen-% bis 30 Volumen-% ist;
Abtasten der Siliziumsubstratoberfläche mit der Substratanalysedüse (62), die die hochkonzentrierte gewonnene Flüssigkeit an einem Spitzenende der Düse (62) hält;
Gewinnen der hochkonzentrierten gewonnenen Flüssigkeit, die Verunreinigungen enthält;
Ausstoßen und Rückführen der hochkonzentrierten gewonnenen Flüssigkeit, die in der Substratanalysedüse (62) gewonnen wurde, auf die Siliziumsubstratoberfläche;
Transportieren und Anordnen des Siliziumsubstrats (W), auf dem die hochkonzentrierte gewonnene Flüssigkeit angeordnet wurde, in eine Trocknungskammer (50) durch den Substrattransportroboter (20);
Unterziehen des Siliziumsubstrats (W) einer Erwärmung und Trocknung;
Transportieren und Abbringen des erwärmten und getrockneten Siliziumsubstrats (W) auf dir Analyseplattform (61) durch den Substrattransportroboter (20);
Füllen der Substratanalysedüse (62) mit einer Analyseflüssigkeit (D), die eine Flüssigkeitsgemisch aus Fluorwasserstoff und Wasserstoffperoxid ist, und Abtasten der Siliziumsubstratoberfläche mit der Analyseflüssigkeit;
Gewinnen der Analyseflüssigkeit (D) durch die Substratanalysedüse (62), Einbringen in einen Analysebehälter, der in einer Analyseflüssigkeitssammeleinrichtung (70) vorgesehen ist; und
Analysieren der Analyseflüssigkeit (D) durch induktiv gekoppelte Plasmamassenspektrometrie (ICP-MS).

3. Verwendung der Siliziumsubstrat-Analysevorrichtung nach Anspruch 1 zum Analysieren von in einem Siliziumsubstrat enthaltenen Verunreinigungen,
worin ein Siliziumsubstrat (W) durch einen Substrattransportroboter (20) aus einer Beschickungsöffnung (10) entnommen wird, zu einer Gasphasenzersetzungskammer (40) transportiert und dort angeordnet wird, worin das Siliziumsubstrat (W) mit einem Ätzgas, das einen Dampf von Fluorwasserstoff enthält, in Kontakt gebracht wird, um eine Gasphasenzersetzungsbehandlung durchzuführen;
wobei das Siliziumsubstrat (W), das der Gasphasenzersetzungsbehandlung unterzogen worden ist, durch den Substrattransportroboter (20) auf die Analyseplattform (61) der Analyseabtastöffnung (60) transportiert und angebracht wird;
eine Substratanalysedüse (62) der Analyseabtastöffnung (60) mit einer hochkonzentrierten gewonnenen Flüssigkeit gefüllt wird, die ein Flüssigkeitsgemisch aus Fluorwasserstoff mit einer Konzentration von 10 Volumen-% bis 30 Volumen-% und Wasserstoffperoxid mit einer Konzentration von 1 Volumen-% bis 30 Volumen-% ist, und worin die Siliziumsubstratoberfläche mit der Substratanalysedüse (62) abgetastet wird, die die hochkonzentrierte gewonnene Flüssigkeit an einem Spitzenende der Düse (62) hält;
wobei die hochkonzentrierte zurückgewonnene Flüssigkeit, die Verunreinigungen enthält, gewonnen wird und die hochkonzentrierte gewonnene Flüssigkeit abgegeben und auf die Siliziumsubstratoberfläche zurückgeführt wird;
wobei das Siliziumsubstrat (W), auf dem die hochkonzentrierte gewonnene Flüssigkeit angeordnet wurde durch den Substrattransportroboter (20) transportiert und in einer Trocknungskammer (50) angeordnet wird und das Siliziumsubstrat (W) einer Erwärmung und Trocknung unterzogen wird;
worin das erwärmte und getrocknete Siliziumsubstrat (W) wird durch den Substrattransportroboter (20) transportiert und auf der Analyseplattform (61) angebracht wird, und die Substratanalysedüse (62) mit einer Analyseflüssigkeit (D) gefüllt wird, die ein Flüssigkeitsgemisch aus Fluorwasserstoff und Wasserstoffperoxid ist;
worin die Siliziumsubstratoberfläche mit der Analyseflüssigkeit (D) abgetastet wird, die Analyseflüssigkeit (D) durch die Substratanalysedüse (62) gewonnen und in einen Analysebehälter gegeben wird, der in einer Analyseflüssigkeitssammeleinrichtung (70) vorgesehen ist;
und die Analyseflüssigkeit (D) durch induktiv gekoppelte Plasmamassenspektrometrie (ICP-MS) analysiert wird.

4. Verfahren nach Anspruch 2 oder Verwendung nach Anspruch 3, worin das Siliziumsubstrat (W) in der Trockenkammer (50) bei einer Heiztemperatur von 100 °C bis 130 °C erwärmt und getrocknet wird.

5. Verfahren nach Anspruch 2 oder Verwendung nach Anspruch 3, worin die gewonnene hochkonzentrierte Flüssigkeit an einer bestimmten Stelle oder an mehreren Stellen verteilt auf die Siliziumsubstratoberfläche abgegeben und auf die Siliziumsubstratoberfläche zurückgeführt wird.

## Revendications

1. Dispositif d'analyse de substrat de silicium (W) comprenant :
un port de chargement (10) permettant de placer sur celui-ci une cassette de stockage qui stocke un substrat de silicium (W) à analyser, où un film d'oxyde et/ou un film de nitrure ayant été formé sur le substrat de silicium (W) ;
un robot de transport de substrat (20) capable d'extraire, de transporter et d'installer le substrat de silicium (W) stocké dans le port de chargement (10) ;
un dispositif d'alignement (30) pour régler une position du substrat de silicium (W) ;
une chambre de séchage (50) pour chauffer et sécher le substrat de silicium (W) ;
une chambre de décomposition en phase gazeuse (40) pour décaper le substrat de silicium (W) avec un gaz de décapage ;
un port de balayage d'analyse (60) ayant une platine d'analyse (61) permettant de monter le substrat de silicium (W) sur celle-ci, et une buse d'analyse de substrat (62) pour balayer une surface du substrat de silicium (W) monté sur la platine d'analyse (61) avec un liquide d'analyse (D) et collecter le liquide d'analyse (D) dans lequel ont été transférées des impuretés telles que des métaux à l'état de traces, le liquide d'analyse (D) étant un mélange liquide de fluorure d'hydrogène et de peroxyde d'hydrogène ;
un moyen de collecte de liquide d'analyse (70) comportant un récipient d'analyse dans lequel mettre le liquide d'analyse (D) récupéré par la buse d'analyse de substrat (62) ;
un nébuliseur aspirant le liquide d'analyse (D) qui a été mis dans le récipient d'analyse ; et
un moyen d'analyse pour effectuer une spectrométrie de masse à plasma à couplage inductif sur le liquide d'analyse (D) fourni par le nébuliseur,
**caractérisé en ce que**
la buse d'analyse de substrat (62) contenant du liquide récupéré à concentration élevée au niveau d'une pointe de la buse (62) est adaptée pour balayer la surface du substrat de silicium, le liquide récupéré à concentration élevée étant un mélange liquide de fluorure d'hydrogène d'une concentration de 10 % à 30 % en volume et de peroxyde d'hydrogène d'une concentration de 1 % à 30 % en volume ; et
la buse d'analyse de substrat (62) est adaptée en outre pour déverser ensuite le liquide récupéré à concentration élevée et le renvoyer sur la surface du substrat de silicium.

2. Procédé d'analyse d'impuretés contenues dans un substrat de silicium à l'aide du dispositif d'analyse de substrat de silicium selon la revendication 1, comprenant
l'extraction d'un substrat de silicium (W) d'un port de chargement (10), le transport du substrat de silicium et sa mise en place dans une chambre de décomposition en phase gazeuse (40) par un robot de transport de substrat (20), le substrat de silicium (W) étant mis en contact avec un gaz de décapage contenant de la vapeur de fluorure d'hydrogène pour effectuer un traitement de décomposition en phase gazeuse ;
le transport et le montage du substrat de silicium (W) ayant été soumis au traitement de décomposition en phase gazeuse et son montage sur la platine d'analyse (61) du port de balayage d'analyse (60) par le robot de transport de substrat (20) ;
le remplissage d'une buse d'analyse de substrat (62) du port de balayage d'analyse (60) avec un liquide récupéré à concentration élevée qui est un mélange liquide de fluorure d'hydrogène d'une concentration de 10 % à 30 % en volume et de peroxyde d'hydrogène d'une concentration de 1 % à 30 % en volume ;
le balayage de la surface du substrat de silicium avec la buse d'analyse de substrat (62) qui contient le liquide récupéré à concentration élevée au niveau d'une pointe de la buse (62) ;
la récupération du liquide récupéré à concentration élevée contenant des impuretés ;
le déversement et son renvoi du liquide récupéré à concentration élevée récupéré dans la buse d'analyse de substrat (62) sur la surface du substrat de silicium ;
le transport du substrat de silicium (W) sur lequel a été placé le liquide récupéré à concentration élevée et sa mise en place dans une chambre de séchage par le robot de transport de substrat (20) ;
la soumission du substrat de silicium (W) à un chauffage et un séchage ;
le transport du substrat de silicium (W) et son montage sur la platine d'analyse (61) du port de balayage d'analyse (60) par le robot de transport de substrat (20) ;
le remplissage de la buse d'analyse de substrat (62) avec un liquide d'analyse (D) qui est un mélange liquide de fluorure d'hydrogène et de peroxyde d'hydrogène, et le balayage de la surface du substrat de silicium avec le liquide d'analyse ;
la récupération du liquide d'analyse (D) par la buse d'analyse de substrat (62), en le mettant dans un récipient d'analyse prévu dans un moyen de collecte de liquide d'analyse (70) ; et
l'analyse du liquide d'analyse (D) par spectrométrie de masse à plasma à couplage inductif (ICP-MS).

3. Utilisation du dispositif d'analyse de substrat de silicium selon la revendication 1 pour analyser des impuretés contenues dans un substrat de silicium,
dans laquelle un substrat de silicium (W) est extrait d'un port de chargement (10) par un robot de transport de substrat (20), transporté et placé dans une chambre de décomposition en phase gazeuse (40), le substrat de silicium (W) étant mis en contact avec un gaz de décapage contenant de la vapeur de fluorure d'hydrogène pour effectuer un traitement de décomposition en phase gazeuse ;
le substrat de silicium (W) ayant été soumis au traitement de décomposition en phase gazeuse est transporté et monté sur la platine d'analyse (61) du port de balayage d'analyse (60) par le robot de transport de substrat (20) ;
une buse d'analyse de substrat (62) du port de balayage d'analyse (60) est remplie avec un liquide récupéré à concentration élevée qui est un mélange liquide de fluorure d'hydrogène d'une concentration de 10 % à 30 % en volume et de peroxyde d'hydrogène d'une concentration de 1 % à 30 % en volume et la surface du substrat de silicium est balayée avec la buse d'analyse de substrat (62) qui contient le liquide récupéré à concentration élevée au niveau d'une pointe de la buse (62) ;
le liquide récupéré à concentration élevée contenant des impuretés est récupéré et le liquide récupéré à concentration élevée est déversé et renvoyé sur la surface du substrat de silicium ;
le substrat de silicium (W) sur lequel avait été placé le liquide récupéré à concentration élevée est transporté et placé dans une chambre de séchage (50) par le robot de transport de substrat (20) et le substrat de silicium (W) est soumis à un chauffage et un séchage ;
le substrat de silicium chauffé et séché (W) est transporté et monté sur la platine d'analyse (61) par le robot de transport de substrat (20) et la buse d'analyse de substrat (62) est remplie avec un liquide d'analyse (D) qui est un mélange liquide de fluorure d'hydrogène et de peroxyde d'hydrogène ;
la surface du substrat de silicium est balayée avec le liquide d'analyse (D), le liquide d'analyse (D) est récupéré par la buse d'analyse de substrat (62) et est mis dans un récipient d'analyse prévu dans un moyen de collecte de liquide d'analyse (70) ; et
le liquide d'analyse (D) est analysé par spectrométrie de masse à plasma à couplage inductif (ICP-MS).

4. Procédé selon la revendication 2 ou utilisation selon la revendication 3, dans lequel le substrat de silicium (W) est chauffé et séché dans la chambre de séchage (50) à une température de chauffage de 100 °C à 130 °C.

5. Procédé selon la revendication 2 ou utilisation selon la revendication 3, dans lequel le liquide récupéré à concentration élevée est déversé et renvoyé sur la surface du substrat de silicium à un endroit précis, ou à une pluralité d'endroits en se dispersant sur la surface du substrat de silicium.
